(19) Europäisches Patentamt
European Patent Office
Office européen des brevets

(11) EP 2 108 688 A1

(12) EUROPEAN PATENT APPLICATION
published in accordance with Art. 153(4) EPC

(43) Date of publication:
**14.10.2009 Bulletin 2009/42**

(21) Application number: **08703107.6**

(22) Date of filing: **11.01.2008**

(51) Int Cl.:
***C09J 163/00*** *(2006.01)* ***C09J 11/02*** *(2006.01)*
***C09J 11/08*** *(2006.01)*

(86) International application number:
**PCT/JP2008/050243**

(87) International publication number:
**WO 2008/084843 (17.07.2008 Gazette 2008/29)**

(84) Designated Contracting States:
**AT BE BG CH CY CZ DE DK EE ES FI FR GB GR HR HU IE IS IT LI LT LU LV MC MT NL NO PL PT RO SE SI SK TR**

(30) Priority: **12.01.2007 JP 2007005092**
**04.06.2007 JP 2007148146**

(71) Applicant: **Sekisui Chemical Co., Ltd.**
**Osaka-shi**
**Osaka 530-8565 (JP)**

(72) Inventors:
- **ISHIZAWA, Hideaki**
**Mishima-gun**
**Osaka 618-8589 (JP)**
- **HAYAKAWA, Akinobu**
**Mishima-gun**
**Osaka 618-8589 (JP)**
- **TAKEDA, Kohei**
**Mishima-gun**
**Osaka 618-8589 (JP)**

(74) Representative: **Hart-Davis, Jason et al**
**Cabinet Beau de Loménie,**
**158, rue de l'Université**
**75340 Paris Cedex 07 (FR)**

# (54) ADHESIVE FOR ELECTRONIC COMPONENTS

(57) The present invention has its object to provide an adhesive for bonding electronic components with a constant distance between them, which makes it possible to maintain a distance between bonded electronic components at high accuracy and to provide a highly reliable electronic apparatus, and which can be stably and continuously applied with a jet dispenser. The present invention is an adhesive for bonding electronic components, including spacer particles, an epoxy compound (A), and a curing agent. The spacer particles have a CV value of 10% or less. The epoxy compound (A) has a molecular structure including 10 or less monomer units with an aromatic ring in each repeating unit, is in a state of crystalline solid at 25˚C, and has a viscosity of 1 Pa·s or less measured by an E-type viscometer at a temperature of 50 to 80˚C.



Printed by Jouve, 75001 PARIS (FR)

## Description

THECNICAL FIELD

The present invention relates to an adhesive for bonding electronic components with a constant distance between the electronic components, which makes it possible to maintain a distance between bonded electronic components at high accuracy and to provide a highly reliable electronic apparatus, and which can be stably and continuously applied with a jet dispenser.

BACKGROUND ART

There has recently been a trend of a three-dimensional packaging technology with a demand for miniaturizing electronic packages; for example, a plurality of semiconductor chips are laminated to provide a multilayer semiconductor chip laminate. Studies have been also advanced for further miniaturizing semiconductor chip laminates.
Accordingly, it has become possible to provide a semiconductor chip as an extremely thin film and further to form a fine circuit on the semiconductor chip. In such a semiconductor chip laminate formed by the three-dimensional packaging technology, each semiconductor chip is required to be horizontally laminated without damage.
Transformer parts and the like have also been miniaturized recently. For example, in an iron core of a coil having air gaps, such as an EI-type iron core and an EE-type iron core, a distance of the air gap is required to be constant and, for example, adhesive is filled into the air gaps. Also in such transformer parts, there is a problem in controlling precisely a distance between air gaps.
In relation to a method for keeping each electronic component of a laminate of electronic components horizontal, for example, the following method is conventionally known; the method includes: applying a die attachment paste containing spacer particles to one electronic component at a surface where the other electronic component is to be laminated thereon, and then laminating the other electronic component thereon (see Patent Document 1).
Upon laminating electronic components via such a die attachment paste containing spacer particles, the electronic components are required to be pressed to the extent that a distance between the electronic components can be ensured by a particle diameter of each spacer particle so as to maintain connection between the electronic components and to keep surely the electronic components horizontal.
Upon using a die attachment paste containing conventional spacer particles even in the case where a distance between electronic components is extremely narrow in a laminate of electronic components, however, adhesive between the spacer particles and the electronic components cannot be sufficiently removed, and unfortunately the electronic components may not be kept in horizontal. Such a problem may be presumably avoided by a method in which a diluent is added to the die attachment paste to reduce viscosity thereof.
In the case of adding a diluent to reduce the viscosity of the die attachment paste, however, an application shape is deformed due to flowing upon applying the paste on the surface of the electronic component. Furthermore, since a diluent which is added so as to reduce viscosity generally contains a large amount of volatile constituents, a die attachment paste containing such a diluent generates voids upon being heated, and thus a laminate of electronic components to be produced is inferior to its reliability.
Bonding of electronic components such as a semiconductor chip to a substrate and surface mounting of various electronic components have been conventionally performed by applying adhesive in a dot pattern. Examples of a method for applying adhesive in a dot pattern include a method in which adhesive ejected from the tip of a needle nozzle is allowed to contact the surface of a substrate and then to form a dot pattern (see Patent Document 2).
In such a method in which adhesive is ejected from a needle nozzle, however, the adhesive is required to contact a substrate and the like, so that the method cannot be employed in the case where the surface of a substrate and the like has a step, and that an amount of the adhesive for forming a dot is unstable.
In such a situation, adhesive application with a jet dispenser has been recently examined because: an adhesive can be applied in a dot pattern in a shorter time period; the amount of the ejected adhesive can be excellently controlled; and application can be performed even in the case where the surface of a substrate has a step.
For stably and continuously applying adhesive with a jet dispenser, the adhesive is required to have high coatability. An example of a method for improving coatability of adhesive is a method in which a diluent is added to the adhesive to reduce viscosity thereof (see Patent Document 3).
Upon applying with a jet dispenser a conventional adhesive having low viscosity due to addition of a diluent, however, dripping at a nozzle, failure in dot formation due to a trouble that fluid ejection does not smoothly stop, or other problems occur. Moreover, even in the case of applying an adhesive successfully in a dot pattern, the formed dot pattern cannot be maintained.
Accordingly, an adhesive for electronic components has not been provided yet, which makes it possible to maintain a distance between bonded electronic components at high accuracy and to provide a highly reliable electronic apparatus,

and which can be stably and continuously applied with a jet dispenser.

Patent Document 1: Japanese Kohyo Publication 2005-503468 (JP-T 2005-503468)
Patent Document 2: Japanese Kokai Publication 2006-286956 (JP-A 2006-286956)
Patent Document 3: Japanese Kokai Publication 2007-059441 (JP-A 2007-059441)

DISCLOSURE OF THE INVENTION

PROBLEMS TO BE SOLVED BY THE INVENTION

Considering the aforementioned situation, the present invention has its object to provide an adhesive for bonding electronic components with a constant distance between them, which makes it possible to maintain a distance between bonded electronic components at high accuracy and to provide a highly reliable electronic apparatus, and which can be stably and continuously applied with a jet dispenser.

MEANS FOR SOLVING THE PROBLEMS

The present invention is an adhesive for bonding electronic components, including spacer particles, an epoxy compound (A), and a curing agent. The spacer particles have a CV value of 10% or less. The epoxy compound (A) has a molecular structure including 10 or less monomer units with an aromatic ring in each repeating unit, is in a state of crystalline solid at 25˚C, and has a viscosity of 1 Pa·s or less measured by an E-type viscometer at a temperature of 50 to 80˚C.
The present invention will be specifically described hereinbelow.
The present inventors have made keen examinations and thereby found that an adhesive for electronic components, which includes: spacer particles having a CV value in a predetermined range; an epoxy compound having a predetermined viscosity characteristic and molecular structure; and a curing agent, has particular viscosity characteristics. The present inventors have also found that such an adhesive makes it possible to maintain a distance between bonded electronic components at high accuracy and to provide an extremely highly reliable electronic apparatus, and can be stably and continuously applied with a jet dispenser upon bonding electronic components with the adhesive. Thus, the present inventors have completed the present invention.
The present invention is an adhesive for bonding electronic components.
The adhesive for electronic components of the present invention contains spacer particles having a CV value of 10% or less. The adhesive containing such spacer particles makes it possible to maintain a distance constant between semiconductor chips upon, for example, laminating two or more semiconductor chips using the adhesive for electronic components of the present invention.
The upper limit of the CV value of the spacer particles is 10%. In the case where the CV value thereof is more than 10%, wide variations occur in particle diameters, and thus, it is difficult to maintain a distance constant between electronic components, and the spacer particles cannot sufficiently exert their function. The desirable upper limit thereof is 6%, and the more desirable upper limit thereof is 4%.
The "CV value" used herein is a value obtained by the following formula (1):

$$\text{CV value of particle diameter (\%)} = (\sigma 2/Dn2) \times 100 \quad (1)$$

In the formula (1), σ2 represents a standard deviation of particle diameters and Dn2 represents a number average particle diameter.
An average particle diameter of the spacer particles is not particularly limited as long as the electronic components are allowed to have a desired distance between them. The desirable lower limit thereof is 5 μm and the desirable upper limit thereof is 200 μm. In the case where the average particle diameter thereof is less than 5 μm, it may be difficult to narrow a distance between electronic components to the similar size of the particle diameters of the spacer particles. In the case where the average particle diameter thereof is more than 200 μm, electronic components may have a distance wider than required. The more desirable lower limit thereof is 9 μm and the more desirable upper limit thereof is 50 μm.
The average particle diameter of the spacer particles is desirably 1.2 or more times larger than an average particle diameter of solid portions added to the adhesive in addition to the spacer particles. In the case where the average particle diameter of the spacer particles is less than 1.2 times larger than the average particle diameter of the solid portions, it may be difficult to reliably narrow a distance between electronic components to the similar size of the particle

diameters of the spacer particles. The average particle diameter of the spacer particles is more desirably 1.1 or more times larger than the average particle diameter of the solid portions.

A standard deviation of the particle diameter distribution of the spacer particles is desirably 10% or less of the average particle diameter of the spacer particles. In the case where the standard deviation thereof is 10% or less of the average particle diameter of the spacer particles, electronic components such as a semiconductor chip can be horizontally laminated with greater stability.

With respect to a K value of the spacer particles represented by the following formula (2), the desirable lower limit thereof is 980 N/mm$^2$ and the desirable upper limit thereof is 4900 N/mm$^2$.

$$K = (3/\sqrt{2}) \cdot F \cdot S^{-3/2} \cdot R^{-1/2} \qquad (2)$$

In the formula (2), F represents a load value (kgf) of resin fine particles in 10% compressive deformation, S represents a compression displacement (mm) of resin fine particles in 10% compressive deformation, and R represents a radius (mm) of the spacer.

The K value can be measured by the following method.

First, particles are dispersed on a steel plate having a flat surface, and then one fine particle selected from among the particles is compressed by a flat end face of a diamond round pillar with a diameter of 50 μm using a micro compression testing apparatus. Upon the compression, a compression load is electrically detected as an electromagnetic force and a compression displacement is electrically detected as a displacement by a differential transformer. Then, a load value and a compression displacement in 10% compressive deformation are determined by the obtained compression displacement-load relationship, and the K value is calculated from the obtained result.

With respect to a compression recovery rate upon releasing the spacer particle from the 10% compressive deformation state at 20°C, the desirable lower limit thereof is 20%. In the case of using the spacer particles having such a compression recovery rate, even a particle having a particle diameter larger than the average particle diameter present between the laminated electronic components can serve as a gap adjuster through recovery of its shape by compressive deformation. Thus, the electronic components can be horizontally laminated with greater stability with a predetermined distance therebetween.

The compression recovery rate can be measured by the following method.

As in the same method for measuring the K value, a compression displacement is electrically detected as a displacement by a differential transformer. The spacer particle is compressed to a reverse load value, and then gradually released from the load. The relationship between the load and the compression displacement at that time is measured. The compression recovery rate is calculated from the obtained measurement result. The terminal load value of the compression release is not zero but an original load value of 0.1 g or more.

A material of the spacer particles is not particularly limited, but the spacer particles are desirably resin particles. A resin for the resin particles is not particularly limited. Examples thereof include polyethylene, polypropylene, polymethyl pentene, polyvinyl chloride, polytetrafluoro ethylene, polystyrene, polymethyl methacrylate, polyethylene terephthalate, polybutylene terephthalate, polyamide, polyimide, polysulfone, polyphenylene oxide, polyacetal, and the like. Crosslinked resins are desirably used because, by using such resins, it is easy to adjust hardness and the recovery rate of the spacer particles and is possible to improve heat resistance of the spacer particles.

The crosslinked resin is not particularly limited. Examples thereof include resins having a mesh structure, such as an epoxy resin, a phenol resin, a melamine resin, an unsaturated polyester resin, a divinylbenzene polymer, a divinylbenzene-styrene copolymer, a divinylbenzene-acrylate copolymer, a diallyl phthalate polymer, a triallyl isocyanurate polymer, and a benzoguanamine polymer. The divinylbenzene polymer, the divinylbenzene-styrene-type copolymer, the divinylbenzene-(meth)acrylate copolymer, the diallyl phthalate polymer and the like are desirably used among these. The adhesive containing these has excellent resistance to heat treatments such as a curing process and a solder reflowing process after chip bonding.

Non-limiting examples of organic-inorganic hybrid spacer particles include particles containing alkoxysilane as a main component. The particles containing alkoxysilane as a main component can be obtained by hydrolysis polycondensation of alkoxysilane in conformity to the description in Japanese Patent No. 2698541 (JP-B 2698541).

Desirably, the surface of the spacer particles is optionally treated.

The adhesive for electronic components of the present invention can achieve the below-mentioned viscosity characteristics by containing the spacer particles with the surface treated.

The surface treating method is not particularly limited. For example, it is desirable to impart a hydrophilic group to the surface in the case where the whole of the adhesive composition has hydrophobicity. A method for imparting the hydrophilic group is not particularly limited. An example thereof is, in the case of using the resin particles as the spacer particles, a method in which the surface of the resin particles is treated with a hydrophilic group-containing coupling agent.

The spacer particles desirably have a spherical shape. The desirable upper limit of an aspect ratio of the spacer particles is 1.1. In the case where the aspect ratio thereof is 1.1 or less, electronic components can be stably laminated with a constant distance. The "aspect ratio" used herein represents a ratio of a length of the major axis to a length of the minor axis of the particles (the value obtained by dividing the length of the major axis by the length of the minor axis). The spacer particles having the aspect ratio closer to 1 have a shape closer to the perfect sphere.

With respect to an amount of the spacer particles to be added, the desirable lower limit thereof is 0.01% by weight and the desirable upper limit thereof is 5% by weight. In the case where the amount of the spacer particles is less than 0.01% by weight, a distance between electronic components may not be stably maintained constant upon producing a laminate of electronic components. In the case where the amount of the spacer particles is more than 5% by weight, the function as adhesive may deteriorate.

In the case where the adhesive contains a solid portion having a diameter equal to or larger than the average particle diameter of the spacer particles in addition to the spacer particles, the desirable upper limit of an amount of the solid portion to be added is 1% by weight. A melting point of the solid portion is desirably equal to or less than a curing temperature.

Furthermore, the maximum particle diameter of the solid portion is desirably 1.1 to 1.5 times, and more desirably 1.1 to 1.2 times, larger than the average particle diameter of the spacer particles.

The adhesive for electronic components of the present invention contains an epoxy compound (A).

The epoxy compound (A) has a molecular structure including 10 or less monomer units with an aromatic ring in each repeating unit. The aforementioned epoxy compound (A) has characteristics that the compound has such an extremely high crystallizability, that the compound is in a state of crystalline solid at 25˚C, and that its viscosity drastically decreases at temperatures higher than 25˚C. This is presumably because the epoxy compound (A) is in a state of crystalline solid at 25˚C as mentioned above but has a low molecular weight owing to a molecular structure containing 10 or less monomer units, so that the crystalline structure is broken by being heated up to higher than 25˚C, resulting in decrease in the viscosity. Specifically, the epoxy compound (A) is in a state of crystalline solid at 25˚C and has the viscosity with the upper limit of 1 Pa·s measured by an E-type viscometer at a temperature of 50 to 80˚C. In the case where the epoxy compound (A) has a molecular structure including more than 10 monomer units and thereby the viscosity at temperatures of 50 to 80˚C is high, the adhesive for electronic components is difficult to laminate the electronic components at substantially the same distance as the particle diameter of the spacer particles, resulting in variations of the distances between the electronic components. The epoxy compound (A) desirably has a molecular structure containing three or less monomer units. The reason for setting the temperature range to 50 to 80˚C in which the viscosity becomes 1 Pa·s is to take into account the temperature conditions upon heating and pressurizing electronic components in the general production process of a laminate of electronic components. Furthermore, the reason for setting the temperature to 25˚C at which the epoxy compound (A) is in a state of crystalline solid is to take into account that an adhesive for bonding electronic components is generally applied at room temperature.

In the case of using, for bonding electronic components and the like, the adhesive for electronic components of the present invention which contains the epoxy compound (A) having such a molecular structure, that is, the molecular structure containing 10 or less monomer units with an aromatic ring in each repeating unit, a distance between the bonded electronic components can be maintained at high accuracy and a highly reliable electronic apparatus can be provided.

In other words, since the epoxy compound (A) having an aromatic ring in each repeating unit is in a state of crystalline solid at 25˚C, the adhesive for electronic components of the present invention containing the epoxy compound (A) has high viscosity at 25˚C. Thus, no deformation of the application shape due to flowing occurs upon applying the adhesive on an electronic component to be bonded. Furthermore, the viscosity of the epoxy compound (A) drastically decreases upon being heated. Thus, for example, in the case of laminating electronic components, one electronic component and another electronic component can be laminated without adhesive residues between the spacer particles and the electronic components while having substantially the same distance as the particle diameter of the spacer particles between the electronic components. Furthermore, the viscosity of the epoxy compound (A) drastically increases as the temperature is cooled down to 25˚C after finishing the lamination of the electronic components, so that the adhesive for electronic components of the present invention does not flow after the lamination of the electronic components.

The adhesive for electronic components of the present invention achieves low viscosity upon being heated by containing the epoxy compound (A). Thus, no void occurs in contrast to the case of using the conventional adhesive with the viscosity lowered by adding only a diluent. Furthermore, the epoxy compound (A) has excellent heat resistance, so that the adhesive for electronic components of the present invention containing the epoxy compound (A) also has excellent heat resistance.

The epoxy compound (A) desirably has two or more epoxy groups per molecule. The adhesive for electronic

components of the present invention containing the epoxy compound (A) with such a molecular structure can exert more excellent adhesiveness.

The epoxy compound (A) is not particularly limited as long as the epoxy compound (A) has the molecular structure mentioned above. Examples thereof include resorcinol-type epoxy, naphthalene-type epoxy, biphenyl-type epoxy, and the like. Examples of commercially available products of such an epoxy compound (A) include EX-201 (produced by Nagase & Co., Ltd), YSLV-80XY (produced by Tohto Kasei Co., Ltd.), and the like.

The epoxy compound (A) desirably has a glycidyl ether group directly linked to the aromatic ring. The epoxy compound (A) having such a glycidyl ether group can be quickly cured. Thus, the adhesive can be quickly cured after the adhesive has been heated to have low viscosity and a distance between electronic components has become a desired distance, and thereby adhesive leakage or displacement of electronic components can be prevented.

The epoxy compound (A) is desirably a compound represented by the following formula (1) (hereinafter, also referred to as an epoxy compound (1)).

[Chem. 1]

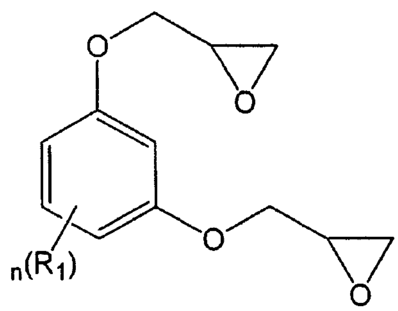

(1)

In the formula (1), $R_1$ represents hydrogen or an alkyl group containing 1 to 3 carbon atoms, and n is the number of substituents and represents an integer of 1 to 4.

Viscosity of the epoxy compound (1) drastically decreases when the epoxy compound (1) is heated, so that such an epoxy compound (1) can be extremely suitably used in an application method using a jet dispenser.
Drastic decrease in the viscosity of the epoxy compound (1) upon heating is presumably resulted from decrease in the crystallizability of the epoxy compound (1) which can maintain the crystallizability at room temperature.

In the case where the epoxy compound (1) and the epoxy compound (A) are used in combination, an adhesive for electronic components to be obtained can have low viscosity at room temperature, and furthermore, can have low viscosity at high temperatures. Also, the adhesive can have excellent usability in dispensation, bonding performance, and adhesive reliability.
Similar to the epoxy compound (A), the epoxy compound (1) is extremely quickly cured when used with a below-mentioned curing agent such as a succinic anhydride. Thus, occurrence of voids in a cured product to be obtained can be extremely effectively reduced in comparison with the case where other reactive diluents are added.

Commercially available products of the epoxy compound (1) are not particularly limited. Examples thereof include EX-201 (produced by Nagase ChemteX Corp.), and the like.

An amount of the epoxy compound (1) to be added is not particularly limited. The desirable lower limit thereof is 20% by weight and the desirable upper limit thereof is 60% by weight. In the case where the amount of the epoxy compound (1) is less than 20% by weight, viscosity of the obtained adhesive for electronic components may be insufficiently reduced, resulting in insufficient increase in storage elastic modulus of a cured product at high temperatures. In the case where the amount of the epoxy compound (1) is more than 60% by weight, an electronic component of the bonded body of electronic components to be obtained may be severely warped. The more desirable lower limit thereof is 30% by weight, the more desirable upper limit thereof is 50% by weight, and the still more desirable upper limit thereof is 40% by weight.

The epoxy compound (A) desirably contains 60% by weight or more of a low-molecular-weight epoxy compound with a number average molecular weight of less than 700.
The adhesive for electronic components of the present invention which contains a curable compound containing such a low-molecular-weight epoxy compound in an amount in the above range and which has the viscosity characteristics in the above range enables continuous and stable application thereof with a jet dispenser. The "number average molecular weight" used herein is a value measured by gel permeation chromatography (GPC) with polystyrene used as a standard. In the gel permeation chromatography, a measurement device produced by Nihon Waters K. K. (column: Shodex GPC

LF-804 (length: 300 mm) produced by Showa Denko K.K. (x2), measurement temperature: 40˚C, flow rate: 1 mL/min, solvent: tetrahydrofuran, standard: polystyrene) is used.

In the case where the amount of the low-molecular-weight epoxy compound in the curable compound is less than 60% by weight, the adhesive for electronic components of the present invention cannot exert the above-mentioned viscosity characteristics. The desirable lower limit thereof is 70% by weight. The upper limit of the amount of the low-molecular-weight epoxy compound in the curable compound is not particularly limited. The curable compound may contain only the low-molecular-weight epoxy compound.

Desirably, the adhesive for electronic components of the present invention further contains a polyfunctional epoxy compound being tri- or more functionalized.

The polyfunctional epoxy compound is desirably a compound represented by the following formula (2) (hereinafter, also referred to as a compound (2)).

[Chem. 2]

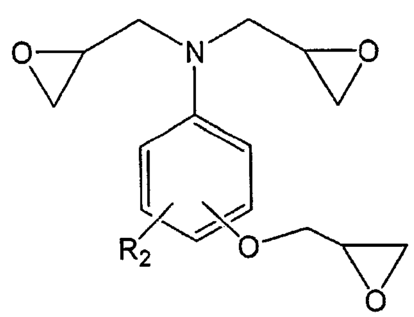

(2)

In the formula (2), $R_2$ represents hydrogen or an alkyl group containing 1 to 3 carbon atoms.

The adhesive for electronic components containing such an epoxy compound (2) can improve bonding reliability of electronic components.

The epoxy compound (2) is extremely quickly cured when used with the below-mentioned curing agent such as a succinic anhydride. The epoxy compound (2) is cured before volatilization thereof if the epoxy compound (2) can be quickly cured, so that occurrence of voids in the obtained cured product can be extremely effectively reduced.

Since the epoxy compound (2) has low viscosity, the adhesive for electronic components of the present invention has relatively low viscosity, is excellent in coatability, and can be used for various application methods. Particularly, the adhesive can be suitably used with a jet dispenser.

Commercially available products of the epoxy compound (2) are not particularly limited. Examples thereof include EP3950S, EP3900S (each produced by ADEKA Corp.), and the like.

The desirable lower limit of an amount of the epoxy compound (2) to be added is 20% by weight and the desirable upper limit thereof is 60% by weight. In the case where the amount of the epoxy compound (2) is less than 20% by weight, storage elastic modulus of the obtained cured product may insufficiently increase at high temperatures, and the viscosity of the obtained adhesive for electronic components may insufficiently reduce. In the case where the amount of the epoxy compound (2) is more than 60% by weight, unreacted epoxy groups may remain, resulting in bad influence on adhesive reliability of the bonded body of electronic components to be obtained. The more desirable lower limit thereof is 30% by weight, the more desirable upper limit thereof is 50% by weight, and the still more desirable upper limit thereof is 40% by weight.

The adhesive for electronic components of the present invention may contain a diluent for the purpose of ensuring coatability at 25˚C, or other purposes.

The diluent is not particularly limited. Examples thereof include a reactive diluent and a non-reactive diluent. Particularly, the reactive diluent can be suitably used.

The reactive diluent is not particularly limited. Suitably used is an epoxy compound (B) containing 10 or less monomer units with an aliphatic cyclic skeleton in each repeating unit. The adhesive for electronic components of the present invention containing the epoxy compound (B) with such a molecular structure can ensure coatability at 25˚C while having high moisture resistance.

The adhesive for electronic components of the present invention containing the epoxy compound (B) with more than 10 monomer units may have high viscosity at 25˚C, possibly resulting in insufficient coatability to electronic components.

The epoxy compound (B) desirably contains 5 or less monomer units.

The epoxy compound (B) is not particularly limited as long as it is a compound having the above-mentioned molecular structure. Examples thereof include a dicyclopentadiene-type epoxy and a cyclohexane-type epoxy. Examples of commercially available products of such an epoxy compound (B) include EP-4088S (produced by ADEKA Corp.) and HP-7200 (produced by Dainippon Ink and Chemicals, Incorp.).

In the case where the adhesive for electronic components of the present invention contains the epoxy compound (B), a ratio of an amount of the epoxy compound (A) and the epoxy compound (B) to be added, that is, the ratio (B/A) or (A/B) has a desirable lower limit of 0.5 and a desirable upper limit of 2. In the case where the ratio is less than 0.5 or more than 2, the amount of either the epoxy compound (A) or the epoxy compound (B) contained therein is too large, resulting in difficulty in imparting characteristics such as the below-mentioned viscosity characteristics and high moisture resistance together to the adhesive for electronic components of the present invention.

For example, in the case where the ratio of the amount of the epoxy compound (A) to the amount of the epoxy compound (B) (the ratio (B/A)) is less than 0.5, the adhesive for electronic components of the present invention may not exert sufficient moisture resistance. In the case where the ratio of the amount of the epoxy compound (B) to the amount of the epoxy compound (A) (the ratio (A/B)) is less than 0.5, the adhesive for electronic components of the present invention may not exert the below-mentioned viscosity characteristics.

A content of the epoxy compound (B) in the adhesive for electronic components of the present invention is not particularly limited. The desirable lower limit thereof is 10 parts by weight and the desirable upper limit thereof is 30 parts by weight to the total of 100 parts by weight of the curable compounds contained in the adhesive for electronic components of the present invention. In the case where the content of the epoxy compound (B) is less than 10 parts by weight, an effect of adding the epoxy compound (B) may be hardly exerted. In the case where the content of the epoxy compound (B) is more than 30 parts by weight, the below-mentioned viscosity characteristics may not be imparted to the adhesive for electronic components of the present invention. The more desirable upper limit thereof is 20 parts by weight.

The adhesive for electronic components of the present invention may contain another epoxy compound (C) as the reactive diluent. Containing such an epoxy compound (C) makes it possible to control viscosity and a glass transition temperature.

The epoxy compound (C) is not particularly limited. Examples thereof include a bisphenol A-type epoxy and a bisphenol F-type epoxy.

A content of the epoxy compound (C) is not particularly limited. The desirable lower limit thereof is 10 parts by weight and the desirable upper limit thereof is 60 parts by weight to the total of 100 parts by weight of the curable compounds contained in the adhesive for electronic components of the present invention. In the case where the content of the epoxy compound (C) is less than 10 parts by weight, an effect of adding the epoxy compound (C) may be hardly exerted. In the case where the content of the epoxy compound (C) is more than 60 parts by weight, the below-mentioned viscosity characteristics may not be imparted to the adhesive for electronic components of the present invention. The more desirable lower limit thereof is 20 parts by weight and the more desirable upper limit thereof is 30 parts by weight.

The adhesive for electronic components of the present invention may contain a polymerizable compound including a reactive functional group as the reactive diluent, which can react with an epoxy group of the epoxy compound (A) and the like. Containing such a polymerizable compound makes it possible to improve bonding reliability of the adhesive for electronic components of the present invention.

The polymerizable compound is not particularly limited. A suitable example thereof is an acrylic-type polymer compound having an epoxy group. Specific examples thereof include an epoxy group-containing acrylic rubber, an epoxy group-containing butadiene rubber, a bisphenol-type high-molecular-weight epoxy resin, an epoxy group-containing phenoxy resin, an epoxy group-containing acrylic resin, an epoxy group-containing urethane resin, and an epoxy group-containing polyester resin.

With respect to a number average molecular weight of the polymerizable compound, the desirable upper limit thereof is 100,000. In the case where the number average molecular weight thereof is more than 100,000, the adhesive for electronic components of the present invention may not exert the below-mentioned viscosity characteristics. The more desirable upper limit thereof is 10,000.

A content of the polymerizable compound is not particularly limited. The desirable lower limit thereof is 1 part by weight and the desirable upper limit thereof is 50 parts by weight to the total of 100 parts by weight of the curable compounds contained in the adhesive for electronic components of the present invention. In the case where the content of the polymerizable compound is less than 1 part by weight, an effect of additionally blending the polymerizable compound may be hardly exerted. In the case where the content of the polymerizable compound is more than 50 parts by weight, the adhesive for electronic components of the present invention may exert inferior adhesive reliability and may not exert the below-mentioned viscosity characteristics. The more desirable upper limit thereof is 20 parts by weight.

The non-reactive diluent is not particularly limited as long as it does not inhibit the object of the present invention. Examples thereof include aromatic hydrocarbons, chlorinated aromatic hydrocarbons, chlorinated aliphatic hydrocarbons, alcohols, esters, ethers, ketones, glycol ethers (cellosolves), alicyclic hydrocarbons, and aliphatic hydrocarbons.
A content of the non-reactive diluent is not particularly limited. The desirable lower limit thereof is 1% by weight and the desirable upper limit thereof is 20% by weight. In the case where the content of the non-reactive diluent is less than 1% by weight, an effect of adding the non-reactive diluent may be hardly exerted. In the case where the content of the non-reactive diluent is more than 20% by weight, voids may occur in a cured product of the adhesive for electronic components of the present invention.

In the case where the adhesive for electronic components of the present invention contains the diluent, the desirable upper limit of a weight loss rate of the diluent at 120˚C and 150˚C is 1%. In the case where the weight loss rate is more than 1%, unreacted substances in the adhesive may volatilize during and after curing of the adhesive for electronic components of the present invention, resulting in bad influence on productivity and on electronic apparatuses to be produced.
Desirably, the diluent has a lower curing starting temperature and is cured at higher rate compared to the curable compounds such as the epoxy compound (A).

The adhesive for electronic components of the present invention contains a curing agent.
The curing agent is not particularly limited and any conventionally-known curing agent can be selected depending on the curable compounds such as the epoxy compound (A) contained in the adhesive for electronic components of the present invention. Specific examples thereof include heat-curing acid anhydride-type curing agents such as trialkyl tetrahydro phthalic anhydride, phenol-type curing agents, amine-type curing agents, latent curing agents such as dicyandiamide, and cationic-type catalytic curing agent. Each of these curing agents may be used alone, or two or more of these may be used in combination.

The curing agent is desirably an acid anhydride compound.
The adhesive containing an acid anhydride as the curing agent can be cured at a high rate. Thus, occurrence of voids in a cured product to be obtained can be extremely effectively reduced, and occurrence of warpage of electronic components in a bonded body of electronic components to be obtained can be extremely effectively reduced.

The curing agent is desirably a succinic anhydride.
The adhesive containing a succinic anhydride can be cured at a high rate. Thus, occurrence of voids in a cured product to be obtained can be extremely effectively reduced, and occurrence of warpage of electronic components in a bonded body of electronic components to be obtained can be extremely effectively reduced.

The succinic anhydride is not particularly limited. Examples thereof include tetrapropenyl succinic anhydride, and the like.

The acid anhydride compound desirably includes a side chain which has 10 or more carbon atoms.
The side chain having 10 or more carbon atoms of the acid anhydride compound exerts flexibility in a cured product to be obtained. In other words, the side chain having 10 or more carbon atoms serves as a flexible skeleton, so that the cured product to be obtained can have flexibility as a whole. Thus, a relatively low elastic modulus at room temperature can be ensured in the cured product to be obtained.

An amount of the curing agent to be added is not particularly limited. In the case of using a curing agent which equivalently reacts with functional groups of the curable compounds such as the epoxy compound (A), the desirable lower limit thereof is 90 equivalents and the desirable upper limit thereof is 110 equivalents to an amount of functional groups of the curable compounds. In the case of using a curing agent which serves as a catalyst, the desirable lower limit thereof is 1 part by weight and the desirable upper limit thereof is 20 parts by weight per 100 parts by weight of the curable compounds.

A curing accelerator may be added to the adhesive for electronic components of the present invention in addition to the curing agent so as to control a curing rate, physical properties of a cured product, and the like.

The curing accelerator is not particularly limited. Examples thereof include an imidazole-type curing accelerator and a tertiary amine-type curing accelerator. Suitably used among these is the imidazole-type curing accelerator because such an accelerator makes it easy to control a reaction system for controlling a curing rate, physical properties of a cured product, and the like. Each of these curing accelerators may be used alone, or two or more of these may be used in combination.

The imidazole-type curing accelerator is not particularly limited. Examples thereof include: 1-cyanoethyl-2-phenylimidazole with the 1-position of imidazole protected by a cyanoethyl group; and a substance with its basicity protected by isocyanuric acid (trade name "2MA-OK", produced by SHIKOKU CHEMICALS Corp.). Each of these imidazole-type curing accelerators may be used alone, or two or more of these may be used in combination.

An amount of the curing accelerator to be added is not particularly limited. The desirable lower limit thereof is 1 part by weight and the desirable upper limit thereof is 10 parts by weight to the total of 100 parts by weight of the curable compounds such as the epoxy compound (A).

With respect to a melting point of at least one of the curing agent and the curing accelerator, the desirable lower limit thereof is 120˚C. In the case where the melting point is 120˚C or more, gelatinization of the adhesive for electronic components of the present invention upon being heated can be prevented, the electronic components can

be suitably bonded to each other, and a distance between the electronic components can be suitably controlled. Desirably, either the curing agent or the curing accelerator is powder.

Examples of the curing agent having the melting point of 120°C or more include: 5-(2,5-dioxotetrahydro-3-furanyl)-3-methyl-3-cyclohexene-1,2-dicarboxylic anhydride; a phenol novolac resin such as TD-2090; a bisphenol A novolac resin such as KH-6021; an ortho-cresol novolac resin such as KA-1165; and dicyandiamide such as EH-3636AS, EH-3842, EH-3780, EH-4339S, EH-4346S (each produced by Asahi Denka Co. Ltd.).
A microcapsule-type curing agent coated with a material having a melting point of 120°C or more can be also suitably used.

Examples of the curing accelerator having a melting point of 120°C or more include 2MZ, 2MZ-P, 2PZ, 2PZ-PW, 2P4MZ, C11Z-CNS, 2PZ-CNS, 2PZCNS-PW, 2MZ-A, 2MZA-PW, C11Z-A, 2E4MZ-A, 2MA-OK, 2MAOK-PW, 2PZ-OK, 2MZ-OK, 2PHZ, 2PHZ-PW, 2P4MHZ, 2P4MHZ-PW, 2E4MZ·BIS, VT, VT-OK, MAVT, and MAVT-OK (each produced by SHIKOKU CHEMICALS Corp.). Particularly, a curing agent which is stable at temperatures below 130°C and is active at 135 to 200°C is desirable; among the above-listed, 2MA-OK and 2MAOK-PW are desirable. Such a curing accelerator makes it possible to exert storage stability, stability to heat in processes, and quick curability at the same time.

In the case of using both the curing agent and the curing accelerator, an amount of the curing agent to be added is desirably equal to or less than the theoretically required equivalent to the epoxy groups contained in the curable compounds such as the epoxy compound (A). In the case where the amount of the curing agent exceeds the theoretically required equivalent, chloride ions may be eluted with water from a cured product. That is, in the case of excessively adding the curing agent, for example, extracting water has a pH of about 4 to 5 upon extracting the eluted constituents with hot water from a cured product of the adhesive for electronic components of the present invention, so that a large amount of the chloride ion may be eluted from the epoxy compound (A). Accordingly, after immersing 1 g of a cured product of the adhesive for electronic components of the present invention in 10 g of pure water at 100°C for 2 hours, a pH of the pure water is desirably 6 to 8 and more desirably 6.5 to 7.5.

The adhesive for electronic components of the present invention may optionally contain an inorganic ion exchanger. Examples of commercially available products of the inorganic ion exchanger include IXE series products (produced by TOAGOSEI Co., Ltd.). With respect to an amount of the inorganic ion exchanger to be added, the desirable lower limit thereof is 1% by weight and the desirable upper limit thereof is 10% by weight.

The adhesive for electronic components of the present invention may optionally contain additives such as a bleeding inhibitor and an adhesion promoter such as an imidazole silane coupling agent.

With respect to a viscosity of the adhesive for electronic components of the present invention measured by an E-type viscometer at 25°C and at 10 rpm, the desirable lower limit thereof is 1 Pa·s and the desirable upper limit thereof is 200 Pa·s. In the case where the viscosity thereof is less than 1 Pa·s, upon applying the adhesive for electronic components of the present invention onto an electronic component, an application shape may be deformed due to flowing. In the case where the viscosity thereof is more than 200 Pa·s, the adhesive for electronic components of the present invention may not be applied uniformly or in a desired shape onto an electronic component such as a semiconductor chip. The more desirable lower limit thereof is 5 Pa·s and the more desirable upper limit thereof is 30 Pa·s.

The adhesive for electronic components of the present invention has a characteristic that a viscosity thereof drastically decreases when heated. Such a phenomenon occurs in the case where the adhesive contains the epoxy compound (A) having the above-mentioned molecular structure. In the adhesive for electronic components of the present invention, such a drastic decrease in viscosity occurs at a temperature range of 50 to 100°C. The "characteristic that a viscosity thereof drastically decreases" used herein does not indicates that "viscosity of the adhesive for electronic components of the present invention gradually decreases to finally a certain value as the temperature rises", but indicates that "viscosity hardly changes until the temperature reaches a certain value, drastically decreases when the temperature rises above a certain value, and thereafter hardly changes although the temperature rises."

With respect to a viscosity of the adhesive for electronic components of the present invention after drastically decreased, the desirable lower limit thereof is 0.1 Pa·s and the desirable upper limit thereof is 20 Pa·s when measured with an E-type viscometer at 10 rpm. In the case where the viscosity thereof is less than 0.1 Pa·s, the adhesive for electronic components of the present invention applied on an electronic component may flow upon bonding electronic components. In the case where the viscosity thereof is more than 20 Pa·s, a distance between the electronic components may not be allowed to be substantially the same as the particle diameter of the spacer particles upon producing a laminate of electronic components using the adhesive for electronic components of the present invention, and thus it may be difficult to maintain the distance between the bonded electronic components at high accuracy. The more desirable lower limit thereof is 1 Pa·s and the more desirable upper limit thereof is 10 Pa·s.

Since the adhesive for electronic components of the present invention contains the epoxy compound (A), voids hardly occur in a cured product upon bonding electronic components. That is, the desirable upper limit of the number of voids with a diameter of 100 μm or less is one per 1 $mm^2$ when the adhesive for electronic components of the present invention is formed into an adhesive layer with a thickness of 10 μm, and the adhesive layer is cured at 170°C for 15 minutes to form a cured product, and then the cured product is left under a temperature of 260°C for 10 seconds. In the case where the number of voids of the cured product per 1 $mm^2$ is more than one, connecting reliability between electronic

components may be insufficient upon bonding the electronic components using the adhesive for electronic components of the present invention.

The adhesive for electronic components of the present invention can be applied with a jet dispenser upon bonding electronic components. With respect to a viscosity measured by an E-type viscometer at room temperature and at 10 rpm, the desirable lower limit thereof is 0.5 Pa·s and the desirable upper limit thereof is 50 Pa·s. In the case where the viscosity thereof is less than 0.5 Pa·s, a shape of the adhesive layer after applied with a jet dispenser may not suitably maintained at room temperature. In the case where the viscosity thereof is more than 50 Pa·s, the adhesive for electronic components of the present invention may accumulate at the tip of a nozzle upon application with a jet dispenser, resulting in failure in ejection. The more desirable lower limit thereof is 1.0 Pa·s, the more desirable upper limit thereof is 20 Pa·s, and the still more desirable upper limit thereof is 15 Pa·s. Even in the case where the lower limit thereof is less than 1.0 Pa·s, the adhesive for electronic components of the present invention can be suitably jet-dispensed by setting a SP value of the whole of the adhesive to 11 or more. In the case where the viscosity thereof is more than 20 Pa·s, it may be required to set the SP value of the whole of the adhesive for electronic components of the present invention to 11 or more, or to set a specific gravity thereof to 2 or more.

The "room temperature" used herein is 25˚C.

With respect to the viscosity of the adhesive for electronic components of the present invention measured by an E-type viscometer at an application temperature depending on a jet dispenser and at 10 rpm, the desirable lower limit thereof is 0.01 Pa·s and the desirable upper limit thereof is 5.0 Pa·s. In the case where the viscosity thereof is less than 0.01 Pa·s, even though the viscosity characteristic at room temperature satisfies the above range, the adhesive with decreased viscosity may wet and spread at the tip of a nozzle, resulting in difficulty in application with a jet dispenser. In the case where the viscosity thereof is more than 5.0 Pa·s, a large amount of the adhesive may adhere to a vicinity of an ejecting port, resulting in difficulty in continuous ejection of the adhesive. The more desirable lower limit thereof is 0.2 Pa·s and the more desirable upper limit thereof is 2.0 Pa·s.

The "application temperature depending on a jet dispenser" used herein is a temperature in a jet dispenser, and the desirable lower limit thereof is 50˚C and the desirable upper limit thereof is 150˚C.

With respect to a thixotropic value of the adhesive for electronic components of the present invention at the application temperature, the desirable lower limit thereof is 1.5 and the desirable upper limit thereof is 5. In the case where the thixotropic value thereof is less than 1.5, the adhesive may wet and spread at the tip of a nozzle, resulting in failure in continuous ejection of the adhesive. In the case where the thixotropic value thereof is more than 5, the adhesive for electronic components of the present invention may accumulate at a nozzle, resulting in failure in ejection of the adhesive. The more desirable lower limit thereof is 2 and the more desirable upper limit thereof is 4. The "thixotropic value" used herein is a value obtained by dividing a viscosity measured with an E-type viscometer at the application temperature and at 0.5 rpm by a viscosity measured at 5 rpm.

With respect to an elastic modulus E of the adhesive for electronic components of the present invention at -55˚C to 125˚C after cured, the desirable lower limit thereof is 1 GPa and the desirable upper limit thereof is 5 GPa. The elastic modulus E of less than 1 GPa may cause insufficient heat resistance. The elastic modulus E of more than 5 GPa may cause concentration of stresses generated by deformation due to temperature change, resulting in bad influence on bonding reliability. The more desirable lower limit thereof is 2 GPa and the more desirable upper limit thereof is 4 GPa. The desirable lower limit of a ratio (elastic modulus E at -55˚C)/(elastic modulus E at 125˚C) is 1 and the desirable upper limit thereof is 3. Particularly in the case where the ratio is more than 3, deformation due to temperature change may be great, resulting in bad influence on bonding reliability. The more desirable lower limit thereof is 2.

The desirable upper limit of a contact angle between the adhesive for electronic components of the present invention and an electronic component to be bonded is 90˚. The contact angle of more than 90˚ may cause troubles such as bonding with inclusion of air bubbles.

A reaction rate of the adhesive for electronic components of the present invention is desirably less than 5% after a lapse of 10 minutes at a temperature from 20 to 120˚C. In the case where the reaction rate is 5% or more, it may be difficult to reach to a target space upon die-bonding.

A curing shrinkage ratio of the adhesive for electronic components of the present invention is desirably less than 1%. In the case where the curing shrinkage ratio is 1% or more, inner stress generated by curing may cause delamination upon producing a laminate of electronic components.

The "curing shrinkage ratio" used herein is a value obtained as a volume shrinkage ratio (%) depending on a difference of specific gravities before and after curing in conformity to JIS A06024. The specific gravities are measured at a measurement temperature of 25˚C.

The adhesive for electronic components of the present invention can be produced, for example, as follows. That is, the curable compounds such as the epoxy compound (A), and the curing agent, and optionally, the diluent, the curing accelerator, other additives, and the like are mixed with one another each in a predetermined amount, and then the spacer particles are mixed thereto.

The mixing method is not particularly limited. Examples thereof include a method using a homodisper, a utility mixer, a

Banbury mixer, a kneader, or other mixers.

A jet dispenser for applying the adhesive for electronic components of the present invention is not particularly limited, and conventionally known apparatuses can be used. Specific examples thereof include DJ-9000 (produced by Asymtek), and the like.

Since the adhesive for electronic components of the present invention has the above-mentioned viscosity characteristics and contains the above-mentioned curable compounds, the adhesive can be continuously and stably applied by a jet dispenser with extremely high coatability.

Examples of an application shape of the adhesive for electronic components of the present invention with a jet dispenser include a line shape, a belt shape, or any other shapes in addition to a dot shape.

Since the adhesive for electronic components of the present invention contains the epoxy compound (A) with the aforementioned viscosity behavior and the spacer particles, a gap can be precisely controlled.

That is, in a generally-performed bonding process, an adhesive for electronic components is applied on a substrate and the like and then an electronic component is bonded therewith. At that time, the bonded electronic component may tilt, resulting in curing of the adhesive for electronic components with the electronic component remaining tilted (see Fig. 1a). The bonded body of electronic components thus obtained is extremely inferior to its reliability.

On the contrary, in the case of using the adhesive for electronic components of the present invention, the adhesive for electronic components of the present invention is applied on a substrate and the like and then an electronic component is bonded therewith. At that time, although the electronic component may temporarily tilt immediately after application (see Fig. 1a), the tilt of the electronic component is immediately corrected by its weight and then the adhesive for electronic components of the present invention is cured. Thus, the electronic component does not tilt finally and a highly reliable bonded body of electronic components with a distance between the electronic component and the substrate maintained at high accuracy (see Fig. 1b).

The reason of this is as follows: the viscosity of the epoxy compound (A) drastically decreases temporarily upon bonding the electronic component under heating, so that, although the electronic component slightly tilts in the bonding process, the tilt can be corrected as though it has a self alignment capability.

Fig. 1a is a view schematically showing a state in which an electronic component tilts upon bonding a substrate and the electronic component using the adhesive for electronic components. Fig. 1b is a view schematically showing a state in which the tilt of the electronic component is corrected by its weight upon bonding the substrate and the electronic component using the adhesive for electronic components. In Figs. 1, reference numeral 1 represents an electronic component, reference numeral 2 represents a substrate, reference numeral 3 represents an adhesive for electronic components, reference numeral 4 represents a spacer, and reference numeral 5 represents a bonded body of electronic components.

An electronic apparatus can be produced by multi-laminating two or more electronic components with the adhesive for electronic components of the present invention and then sealing with a sealant or the like. Such an electronic apparatus is also one aspect of the present invention. The adhesive for electronic components of the present invention can be particularly suitably used for laminating electronic components in a cross pattern.

The adhesive for electronic components of the present invention can be suitably used for not only laminating two or more electronic components but also laminating an electronic component on a substrate and for bonding components such as a sensor.

In the case of multi-laminating two or more electronic components with the adhesive for electronic components of the present invention, a distance between the electronic components is desirably 1 to 1.5 times of the diameter of the spacer particles. In the case where the distance between the electronic components is less than the particle diameter, the adhesive for electronic components between the spacer particles and the electronic components may not be removed and the distance between the electronic components may not be controlled by the spacer particles, resulting in variations in heights. In the case where the distance between the electronic components is more than 1.5 times of the particle diameter, the distance between the electronic components may not be controlled by the diameter of the spacer particles, resulting in wide variations in heights. The distance between the electronic components is desirably equal to the diameter of the spacer particles.

In the case where the distance between the electronic components is equal to the particle diameter, the adhesive for electronic components of the present invention between the spacer particles and the electronic components can be suitably removed and the distance between the electronic components can be suitably controlled by the spacer particles, resulting in prevention of variations in heights.

An electronic component to be bonded by the adhesive for electronic components of the present invention is not particularly limited. Examples thereof include a semiconductor chip, a sensor, and an EI-type or EE-type iron core for a transformer part, which are conventionally known components to be bonded to a target object at a constant distance.

Fig. 2 is a cross-sectional view schematically showing an EI-type iron core of a coil for a transformer part formed by using the adhesive for electronic components of the present invention.

As shown in Fig. 2, an iron core 10 of a coil for a transformer part is configured such that an E-type core member 11

and an I-type core member 15 are combined with each other so as to form a gap between an outer leg 12 and a central leg 13 of the E-type core member 11 and the I-type core member 15. In the aforementioned iron core 10 of a coil, a gap layer 14 of the adhesive for electronic components of the present invention is formed between the outer leg 12 of the E-type core member 11 and the I-type core member 15. The spacer particles 16 maintain the gap constant between the E-type core member 11 and the I-type core member 15.

EFFECTS OF THE INVENTION

The present invention can provide an adhesive for bonding electronic components with a constant distance between them, which makes it possible to maintain a distance between bonded electronic components at high accuracy and to provide a highly reliable electronic apparatus, and which can be stably and continuously applied with a jet dispenser.

BEST MODE FOR CARRYING OUT THE INVENTION

The present invention will be further described hereinbelow with reference to examples, but not limited to these examples.
For measurement of a particle diameter in each of examples and comparative examples, a particle size measuring apparatus (Coulter counter ZB/C-1000, produced by Coulter Electronics Ltd.) was used, and for measurement of a K value and a compression recovery rate, a micro compression testing apparatus (FISCHERSCOPE H100C, produced by Fischer Instruments K.K.) was used.

(Examples and Comparative Examples)

According to each formulation shown in Table 1, the below-mentioned materials other than the spacer particles were mixed under stirring with a homodisper to prepare an adhesive composition. To the obtained adhesive composition was blended the spacer particles according to the formulation shown in Table 1, and then the mixture was further mixed under stirring with the homodisper to prepare an adhesive for electronic components. In Table 1, each amount of the formulation is shown in parts by weight.

(Epoxy compound (A))

Resorcinol-type epoxy (EX-201, produced by Nagase & Co., Ltd., monomer, crystalline solid at 25˚C, melting point: 30 to 60˚C, viscosity at 50˚C: 250 mPa·s)
Crystalline epoxy resin (YSLV-80XY, produced by Tohto Kasei Co., Ltd., monomer, crystalline solid at 25˚C, melting point: 80˚C, viscosity at 80˚C: 1 Pa·s)

(Polyfunctional epoxy compound)

EP3950S, EP3900S (each produced by ADEKA Corp.)

(Epoxy compound (B))

Dicyclopentadiene-type epoxy (EP-4088S, produced by ADEKA Corp., monomer)
Dicyclopentadiene-type epoxy compound (HP-7200, produced by Dainippon Ink and Chemicals, Incorp., pentamer)

(Other epoxy compounds)

Bisphenol A-type epoxy compound (EP828, produced by Japan Epoxy Resins Co., Ltd., viscosity at 50˚C: 2 Pa·s)
Naphthalene-type epoxy compound (HP-4032D, liquid at normal temperature, produced by Dainippon Ink and Chemicals, Incorp., viscosity at 50˚C: 5 Pa·s)
Bisphenol A-type epoxy compound (EP-1001, produced by Japan Epoxy Resins Co., Ltd., solid at normal temperature, viscosity at 80˚C: 20 Pa·s)
Phenol-type epoxy compound (EX-141, produced by Nagase & Co., Ltd., liquid at normal temperature, viscosity at 50˚C: 7 mPa·s)
NBR-modified bis A-type epoxy compound (EPR-4030, produced by ADEKA Corp., liquid at normal temperature, viscosity at 50˚C: 50 Pa·s)
Bisphenol A-type epoxy compound (YL-980, produced by Japan Epoxy Resins Co., Ltd.)

Cyclohexane-type epoxy compound (ZX-1658, produced by Tohto Kasei Co., Ltd.)
Polypropylene-type epoxy compound (EX-931, produced by Nagase ChemteX Corp.)

(Epoxy group-containing acrylic-type polymer compound)

Epoxy group-containing acrylic resin (BLEMMER CP-30, produced by Japan Epoxy Resins Co., Ltd.)

(Curing agent)

Acid anhydride (YH-306, produced by Japan Epoxy Resins Co., Ltd.)
Acid anhydride (YH-307, produced by Japan Epoxy Resins Co., Ltd.)
Succinic anhydride (DDSA, produced by New Japan Chemical Co., Ltd.)

(Curing accelerator)

Imidazole compound (2MA-OK, produced by SHIKOKU CHEMICALS Corp.)
Thickener (R202, produced by NIPPON AEROSIL CO., LTD.)
(Adhesion promoter)
Imidazole silane coupling agent (SP-1000, produced by Nikko Materials Co., Ltd.)
(Spacer particles)
Resin particles (Micropearl SP-210, produced by SEKISUI CHEMICAL CO., LTD., average particle diameter: 10 μm, CV value: 4%)

(Production of semiconductor chip laminate)

The obtained adhesive for electronic components was charged into a 10-mL syringe (produced by Iwashita Engineering, Inc.), and a precise nozzle (produced by Iwashita Engineering, Inc., nozzle tip diameter: 0.3 mm) was attached to the tip of the syringe. Thereafter, the adhesive was applied on a glass substrate with a dispenser (SHOT MASTER 300, produced by Musashi Engineering, Inc.) under the following conditions: that is, ejecting pressure: 0.4 MPa, gap between semiconductor chip and needle: 200 μm, and application amount: 5 mg.
After the application, a semiconductor chip (chip 1) (thickness: 80 μm, size: 8 mm × 12 mm square, mesh pattern, aluminum wiring: thickness of 0.7 μm, L/S = 15/15, thickness of silicon nitride film on surface: 1.0 μm) having 172 pad openings with a size of 110 μm on the periphery was laminated by being pressed with a flip chip bonder (DB-100, produced by SHIBUYA KOGYO CO., LTD.) for 5 seconds at a pressure of 0.15 MPa and at a temperature of 60°C or 80°C. Next, the adhesive for electronic components was applied on the chip 1 with the above dispenser. Thereafter, a semiconductor chip (chip 2) similar to the chips 1 was placed on the chips 1 with the above bonder such that the long side of the chip 1 and the long side of the chip 2 crossed each other, and then laminated by being pressed for 5 seconds at 0.15 MPa and at a temperature of 60°C or 80°C. Subsequently, the obtained laminate was left in a hot-air drying furnace for 60 minutes at 80°C and then heated for 60 minutes at 150°C to cure the adhesive for electronic components; thereby producing a semiconductor chip laminate.

(Evaluation)

According to the below-mentioned methods, evaluations were performed on the adhesive for electronic components and the semiconductor chip laminate produced in each of the examples and the comparative examples. Table 1 shows the results.

(1) Measurement of viscosity

A viscosity was measured by an E-type viscometer (trade name: VISCOMETER TV-22, produced by TOKI SANGYO CO., LTD., rotor used therein: ϕ 15 mm, preset temperature: 25°C) at a number of rotations of 10 rpm and at each temperature of 25°C, 50°C, and 80°C.

(2) Measurement of thixotropic value

A thixotropic ratio Ti (0.5/5) was calculated by dividing a viscosity measured with the E-type viscometer at 0.5 rpm and at 50°C by a viscosity measured at 5 rpm.

(3) Measurement of SP value

A SP value of the adhesive for electronic components obtained in each of the examples and the comparative examples was calculated as a molar average of SP values of the epoxy compounds used therein.

(4) Retentivity of application shape

Application shape retentivity after the application of the adhesive on the glass substrate was evaluated based on the following criteria.

×: The application shape was deformed during the period from immediately after the application to the bonding, that is, the desirable shape was not retained.
○: The desirable application shape was retained during the period from immediately after the application to the bonding.

(5) Variations in distances between chips

With respect to the semiconductor chip laminate produced in each of the examples and the comparative examples, 10 samples were prepared. Each semiconductor chip laminate was measured for its laminating condition by a laser displacement sensor (KS-1100, produced by KEYENCE Corp.). Specifically, a step height between the upper surface of the chip 1 and the upper surface of the chip 2 was first measured, and a chip thickness was then subtracted from the measured value to calculate a distance between the chip 1 and the chip 2. Thereafter, the variations of the distances between the chips were calculated as 3σ (σ: standard deviation).
Both a condition after lamination and before curing and a condition after curing were evaluated.

(6) Presence of reflow crack

The obtained semiconductor chip laminate was left for 24 hours in a constant-temperature and high-humidity oven at 85˚C and at 85%, and then put into an IR reflow furnace which maintained temperature at 230˚C or more for 20 seconds or more and had the highest temperature of 260˚C. After the putting, the semiconductor device was observed for checking presence of reflow cracks by a Scanning Acoustic Tomograph (SAT). In Table 1, the number of reflow cracks was shown as a fraction defective.

(7) Applicability for jet dispensing process

Applicability for a jet dispensing process was evaluated using a jet dispenser (DJ-9000, produced by Asymtek). Parts used in the evaluation were a nozzle (No. 4, 100 μm diameter), a valve (C-03, 380 μm), and a needle assembly (No. 16, 2.4 mm). Ejecting conditions were as follows: nozzle temperature: 50˚C or 80˚C; stroke: 780 μm; fluid pressure: 1000 kPa; valve pressure: 558 kPa; valve-on time: 5 ms; valve-off time: 5 ms; and nozzle height: 1.0 mm.
Applicability was evaluated based on the following criteria.

○: Ejection continued for 30 minutes at a nozzle temperature of 50˚C or 80˚C.
×: Ejection stopped before a lapse of 30 minutes.

(8) Warpage

With respect to the semiconductor chip laminate produced in each of Examples 1 to 7 and Comparative Example 7, warpage level was measured along diagonals of the semiconductor chip by a laser displacement sensor (produced by KEYENCE Corp., LT9010M, KS-1100). Specifically, a height difference between the center of each side and the chip center of the chip 2 was measured, and then the obtained differences were averaged. The measurement was performed on 10 samples.

(9) Voids

A glass epoxy substrate which took up moisture for 168 hours at 23˚C and at 60% was prepared.
A single semiconductor chip was bonded to the substrate in the same manner as in Example 1 using the adhesive obtained in each of Example 2 and Example 5. The obtained laminate was left for 24 hours in a high-temperature and high-humidity oven at 85˚C and at 85%. Thereafter, the laminate was put into an IR reflow furnace which maintained

temperature at 230˚C or more for 20 seconds or more and had the highest temperature of 260˚C. After the putting, the semiconductor device was observed for checking presence of reflow cracks and voids by a Scanning Acoustic Tomograph (SAT).

In the case of using the adhesive in Example 2, voids corresponding to 7% of the bonding area were observed. In the case of using the adhesive in Example 5, no voids were observed. This was presumably because the adhesive obtained in Example 5 was quickly cured, and thereby occurrence of voids was prevented even in the case where the substrate had taken moisture.

(10) Comprehensive evaluation

Comprehensive evaluation on the adhesive for electronic components and the semiconductor chip laminate obtained in each of the examples and the comparative examples was performed according to the below criteria:

◎: Adhesive excellent in applicability for a jet dispensing process, excellent in retentivity of application shape, capable of controlling a distance between chips at extremely high accuracy, and capable of providing semiconductor chip laminate with warpage of 80 μm or less and having high preventability of reflow crack.
○: Adhesive excellent in applicability for a jet dispensing process, excellent in retentivity of application shape, capable of controlling a distance between chips at extremely high accuracy, and capable of providing a semiconductor chip laminate with warpage of 130 μm or less and having high preventability of reflow crack.
×: Adhesive poor in at least one of the above evaluations.

[Table 1]

| | | | | Example 1 | Example 2 | Example 3 | Example 4 | Example 5 | Example 6 | Example 7 |
|---|---|---|---|---|---|---|---|---|---|---|
| Adhesive for semiconductor components | Composition | Epoxy (A) | EX-201 | 40 | 20 | 30 | 10 | 20 | 20 | 80 |
| | | | YSLV-80XY | - | - | - | - | - | - | - |
| | | Polyfunctional epoxy | EP3900S | - | - | - | - | 10 | 10 | - |
| | | Other epoxy | EP-4088S | 0 | 20 | 10 | 30 | 10 | 10 | - |
| | | | HP-7200 | - | - | - | - | - | - | - |
| | | | EP-828 | 10 | 10 | 10 | 10 | 10 | 10 | - |
| | | | HP-4032D | 50 | 50 | 50 | 50 | 50 | 50 | - |
| | | | EP-1001 | - | - | - | - | - | - | - |
| | | | EX-141 | - | - | - | - | - | - | - |
| | | | EPR-4030 | - | - | - | - | - | - | 20 |
| | | | ZX-1658 | - | - | - | - | - | - | - |
| | | | EX-931 | - | - | - | - | - | - | - |
| | | Polymerizable compound | CP-30 | 2 | 8 | 8 | 8 | 2 | - | - |
| | | Curing agent | YH-306 | 74 | 74 | 74 | 74 | - | - | - |
| | | | YH-307 | - | - | - | - | 70 | 50 | 70 |
| | | | DDSA | - | - | - | - | - | 40 | - |
| | | Curing catalyst | 2MA-OK | 9 | 9 | 9 | 9 | 8 | 8 | 8 |
| | | Additive | Thickener (R202) | 8 | 8 | 8 | 8 | 6 | 6 | 6 |
| | | | Silane coupling agent | 2 | 2 | 2 | 2 | - | - | - |
| | Spacer | | SP-210 | 0.1 | 0.1 | 0.1 | 0.1 | 0.1 | 0.1 | - |
| | | | GS-260 | - | - | - | - | - | - | 0.5 |

(continued)

| | | | Example 1 | Example 2 | Example 3 | Example 4 | Example 5 | Example 6 | Example 7 |
|---|---|---|---|---|---|---|---|---|---|
| Evaluation | Temperature at pressure bonding | | 60˚C | 60˚C | 60˚C | 60˚C | 50˚C | 50˚C | 25˚C |
| | Viscosity (temperature at pressure bonding) | | 0.2 | 1 | 0.7 | 2 | 2 | 1 | 7 |
| | Viscosity | 25˚C | 8 | 8 | 8 | 8 | 8 | 7 | 7 |
| | | 50˚C | 1 | 2 | 1.5 | 3 | 2 | 1 | 2 |
| | | 80˚C | 0.01 | 0.1 | 0.05 | 0.1 | 0.1 | 0.05 | 0.1 |
| | Thixotropic ratio at application temperature | | 4 | 4 | 4 | 4 | 4 | 4 | 3.7 |
| | SP value | | 11 | 11 | 11 | 10 | - | - | 12 |
| | Retentivity of shape | | ○ | ○ | ○ | ○ | ○ | ○ | ○ |
| | Distance between chips (μm) | | 10 | 10 | 10 | 10 | 10 | 10 | 61 |
| | Variations in chip heights after lamination and before curing (3σ) | | 7 | 6 | 7 | 6 | 6 | 6 | 15 |
| | Variations in chip heights after curing (3σ) | | 0.8 | 0.8 | 1 | 1.1 | 0.8 | 0.8 | 5 |
| | Fraction defective | | 2/6 | 0/6 | 1/6 | 1/6 | 0/6 | 0/6 | 0/6 |
| | Applicability for jet dispensing process | | ○ | ○ | ○ | ○ | ○ | ○ | ○ |
| | Warpage (μm) | | 100 | 70 | 90 | 60 | 50 | 60 | 130 |
| | Comprehensive evaluation | | ○ | ◎ | ○ | ○ | ◎ | ◎ | ○ |

[Table 2]

| | | | | Comparative Example 1 | Comparative Example 2 | Comparative Example 3 | Comparative Example 4 | Comparative Example 5 | Comparative Example 6 | Comparative Example 7 |
|---|---|---|---|---|---|---|---|---|---|---|
| Adhesive for semiconductor components | Composition | Epoxy (A) | EX-201 | - | - | - | 40 | - | - | - |
| | | | YSLV-80XY | - | - | - | - | - | - | - |
| | | Polyfunctional epoxy | EP3900S | - | - | - | - | - | - | - |
| | | Other epoxy | EP-4088S | - | - | - | - | 20 | - | - |
| | | | HP-7200 | - | - | - | - | - | 70 | - |
| | | | EP-828 | 10 | 10 | 10 | 10 | - | - | 80 |
| | | | HP-4032D | 50 | 60 | 60 | 60 | - | 30 | - |
| | | | EP-1001 | 40 | - | - | - | - | - | - |
| | | | EX-141 | - | 30 | - | - | - | - | - |
| | | | EPR-4030 | - | - | 30 | - | 50 | - | 20 |
| | | | ZX-1658 | - | - | - | - | 20 | - | - |
| | | | EX-931 | - | - | - | - | 10 | - | - |
| | | Polymerizable compound | CP-30 | 8 | 8 | 8 | 2 | - | - | - |
| | | Curing agent | YH-306 | 74 | 74 | 74 | 74 | - | - | - |
| | | | YH-307 | - | - | - | - | 35 | 40 | 70 |
| | | | DDSA | - | - | - | - | - | - | - |
| | | Curing catalyst | 2MA-OK | 9 | 9 | 9 | 9 | 6 | 8 | 8 |
| | | Additive | Thickener (R202) | 8 | 8 | 8 | 8 | - | 8 | 6 |
| | | | Silane coupling agent | 2 | 2 | 2 | 2 | - | - | - |
| | Spacer | | SP-210 | 0.1 | 0.1 | 0.1 | - | - | - | - |
| | | | GS-260 | - | - | - | - | - | - | 0.5 |

(continued)

| | | | Comparative Example 1 | Comparative Example 2 | Comparative Example 3 | Comparative Example 4 | Comparative Example 5 | Comparative Example 6 | Comparative Example 7 |
|---|---|---|---|---|---|---|---|---|---|
| Evaluation | Temperature at pressure bonding | | 60˚C | 60˚C | 60˚C | 60˚C | 50˚C | 50˚C | 25˚C |
| | Viscosity (temperature at pressure bonding) | | 20 | 0.2 | 31 | 0.2 | 1.2 | 30 | 12 |
| | Viscosity | 25˚C | 95 | 5 | 122 | 8 | 5 | 55 | 12 |
| | | 50˚C | 30 | 1 | 50 | 1 | 1.2 | 30 | 4 |
| | | 80˚C | 10 | 0.01 | 10 | 0.01 | 0.2 | 5.5 | 0.2 |
| | Thixotropic ratio at application temperature | | 4 | 4 | 4 | 4 | 1.2 | 2.7 | 3.5 |
| | SP value | | 11 | 11 | 11 | 11 | 9 | 11 | 12 |
| | Retentivity of shape | | ○ | × | ○ | ○ | × | ○ | ○ |
| | Distance between chips (μm) | | 23 | 10 | 35 | 5 | 5 | 7 | 75 |
| | Variations in chip heights after lamination and before curing (3σ) | | 12 | 7 | 15 | - | - | - | 12 |
| | Variations in chip heights after curing (3σ) | | 5.2 | 0.6 | 7.8 | 3.2 | 2 | 4 | 10 |
| | Fraction defective | | 0/6 | 6/6 | 1/6 | 2/6 | 1/6 | 0/6 | 0/6 |
| | Applicability for jet dispensing process | | × | ○ | × | ○ | × | × | ○ |
| | Warpage (μm) | | - | - | - | - | - | - | 140 |
| | Comprehensive evaluation | | × | × | × | × | × | × | × |

INDUSTRIAL APPLICABILITY

The present invention can provide an adhesive for bonding electronic components with a constant distance between them, which makes it possible to maintain a distance between bonded electronic components at high accuracy and to provide a highly reliable electronic apparatus, and which can be stably and continuously applied with a jet dispenser.

BRIEF DESCRIPTION OF THE DRAWINGS

[Fig. 1a] Fig. 1a is a view schematically showing a state in which an electronic component tilts upon bonding a substrate and the electronic component using an adhesive for electronic components.
[Fig. 1b] Fig. 1b is a view schematically showing a state in which a tilt of an electronic component is corrected by its weight upon bonding a substrate and the electronic component using the adhesive for electronic components of the present invention.
[Fig. 2] Fig. 2 is a cross-sectional view schematically showing an EI-type iron core of a coil for a transformer part formed by using the adhesive for electronic components of the present invention.

EXPLANATION OF SYMBOLS

1 electronic component
2 substrate
3 adhesive for electronic components
4 spacer
5 bonded body of electronic components
10 iron core of coil
11 E-type core member
12 outer leg
13 central leg
14 gap layer
15 I-type core member
16 spacer particles

**Claims**

**1.** An adhesive for bonding electronic components, comprising:

spacer particles;
an epoxy compound (A); and
a curing agent,
the spacer particles having a CV value of 10% or less,
the epoxy compound (A) having a molecular structure including 10 or less monomer units with an aromatic ring in each repeating unit, being in a state of crystalline solid at 25˚C, and having a viscosity of 1 Pa·s or less measured by an E-type viscometer at a temperature of 50 to 80˚C.

**2.** The adhesive for electronic components according to claim 1,
wherein the spacer particles are resin particles or organic-inorganic hybrid particles.

**3.** The adhesive for electronic components according to claim 1 or 2,
wherein the epoxy compound (A) includes two or more epoxy groups per molecule.

**4.** The adhesive for electronic components according to claim 1, 2 or 3,
wherein the epoxy compound (A) includes a glycidyl ether group directly linked to the aromatic ring.

**5.** The adhesive for electronic components according to claim 1, 2, 3 or 4,

wherein the epoxy compound (A) is a compound represented by the following formula(1):

[Chem. 1]

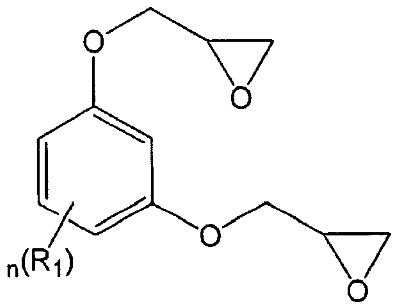

(1)

wherein $R_1$ represents hydrogen or an alkyl group containing 1 to 3 carbon atoms; and n is the number of substituents and represents an integer of 1 to 4.

**6.** The adhesive for electronic components according to claim 1, 2, 3, 4 or 5,
wherein the epoxy compound (A) contains 60% by weight or more of a low-molecular-weight epoxy compound having a number average molecular weight of less than 700.

**7.** The adhesive for electronic components according to claim 1, 2, 3, 4, 5 or 6, further comprising:

a polyfunctional epoxy compound being tri- or more functionalized.

**8.** The adhesive for electronic components according to claim 1, 2, 3, 4, 5, 6 or 7,
wherein the polyfunctional epoxy compound is a compound represented by the following formula (2):

[Chem. 2]

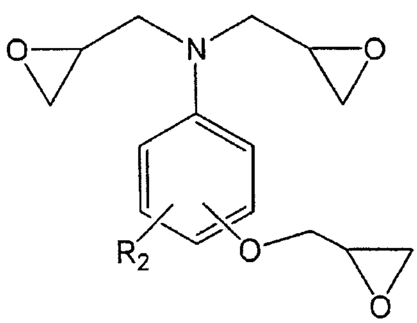

(2)

wherein $R_2$ represents hydrogen or an alkyl group containing 1 to 3 carbon atoms.

**9.** The adhesive for electronic components according to claim 1, 2, 3, 4, 5, 6, 7 or 8,
wherein the curing agent is an acid anhydride compound having a side chain that contains 10 or more carbon atoms.

**10.** The adhesive for electronic components according to claim 1, 2, 3, 4, 5, 6, 7, 8 or 9,
wherein the curing agent is a succinic anhydride.

**11.** The adhesive for electronic components according to claim 1, 2, 3, 4, 5, 6, 7, 8, 9 or 10,
wherein a viscosity measured by the E-type viscometer at room temperature and at 10 rpm is 0.5 to 50 Pa·s, and a viscosity measured by the E-type viscometer at an application temperature depending on a jet dispenser and at 10 rpm is 0.01 to 5.0 Pa·s.

**12.** The adhesive for electronic components according to claim 1, 2, 3, 4, 5, 6, 7, 8, 9, 10 or 11, wherein a thixotropic value at an application temperature is 1.5 to 5.

[Fig. 1a]

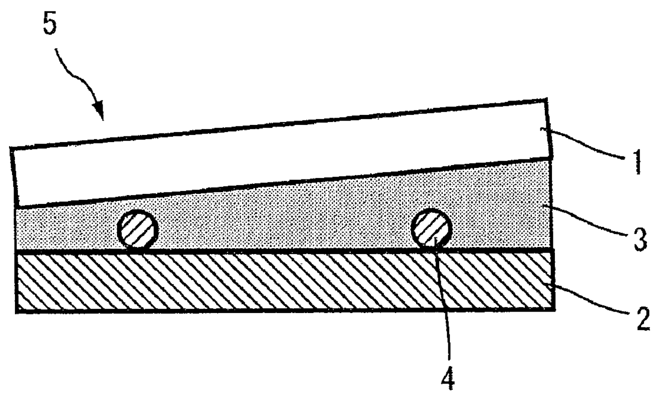


[Fig. 1b]

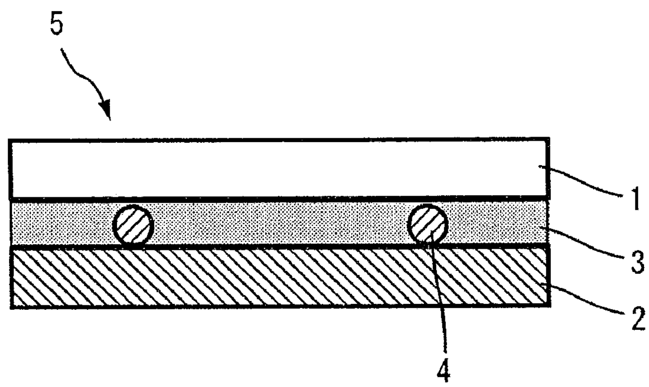


[Fig. 2]

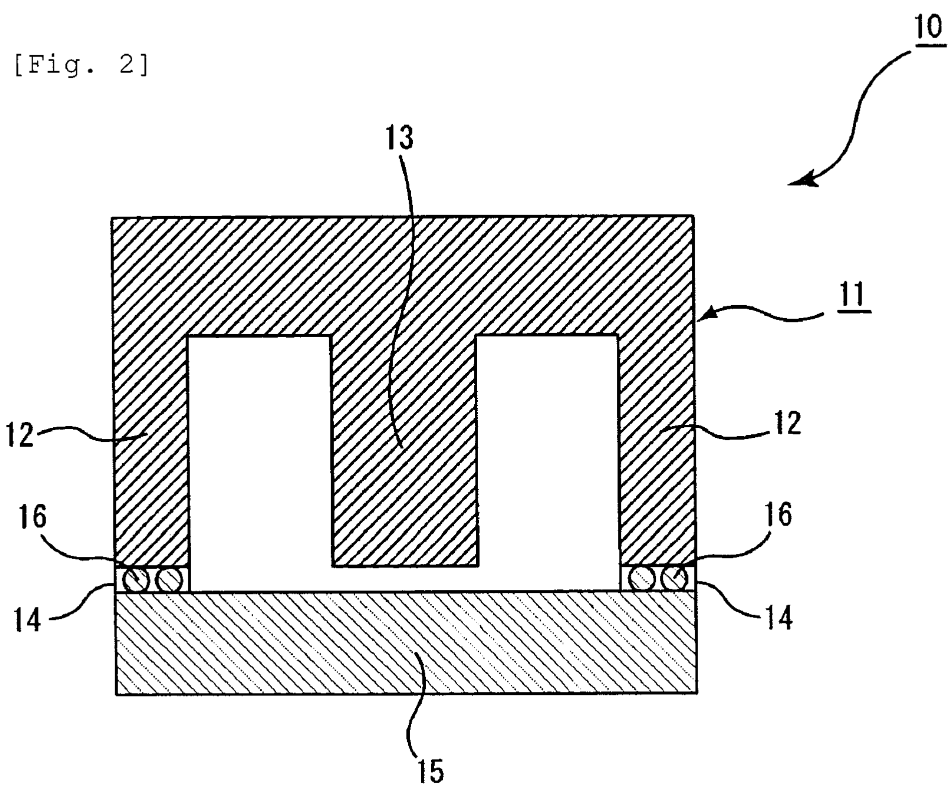

**INTERNATIONAL SEARCH REPORT**

International application No.
PCT/JP2008/050243

A. CLASSIFICATION OF SUBJECT MATTER
*C09J163/00*(2006.01)i, *C09J11/02*(2006.01)i, *C09J11/08*(2006.01)i

According to International Patent Classification (IPC) or to both national classification and IPC

B. FIELDS SEARCHED

Minimum documentation searched (classification system followed by classification symbols)
C09J163/00, C09J11/02, C09J11/08

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2008 |
| Kokai Jitsuyo Shinan Koho | 1971-2008 | Toroku Jitsuyo Shinan Koho | 1994-2008 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| Y | JP 2001-19928 A (Dow Corning Toray Silicone Co., Ltd.), 23 January, 2001 (23.01.01), Claims & US 6750550 B1 & EP 1067163 A1 | 1-12 |
| Y | JP 2002-284845 A (Sumitomo Bakelite Co., Ltd.), 03 October, 2002 (03.10.02), Claim 1; Par. No. [0006] (Family: none) | 1-12 |
| Y<br>A | JP 62-161816 A (Sumitomo Chemical Co., Ltd.), 17 July, 1987 (17.07.87), Page 1, lower right column & US 4900848 A & US 4957995 A & EP 217657 A2 | 7,8<br>1-6,9-12 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 05 March, 2008 (05.03.08) | 18 March, 2008 (18.03.08) |

| Name and mailing address of the ISA/ | Authorized officer |
|---|---|
| Japanese Patent Office | |
| Facsimile No. | Telephone No. |

Form PCT/ISA/210 (second sheet) (April 2007)

**INTERNATIONAL SEARCH REPORT**

International application No.
PCT/JP2008/050243

C (Continuation). DOCUMENTS CONSIDERED TO BE RELEVANT

| Category* | Citation of document, with indication, where appropriate, of the relevant passages | Relevant to claim No. |
|---|---|---|
| A | JP 2005-503468 A (Dow Corning Corp.), 03 February, 2005 (03.02.05), Claim 12 & WO 2003/025081 A1 & US 2003/54162 A1 | 1-12 |
| A | JP 2003-165826 A (Mitsui Chemicals, Inc.), 10 June, 2003 (10.06.03), Claims & US 2003/144381 A1 | 1-12 |

Form PCT/ISA/210 (continuation of second sheet) (April 2007)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2005503468 A
- JP 2005503468 T
- JP 2006286956 A
- JP 2007059441 A
- JP 2698541 B
- EP 3950S A
- EP 3900S A
- EP 4088S A
- EP 828 A
- EP 1001 A